# EUROPEAN PATENT SPECIFICATION

(11) **EP 2 582 857 B1**
(45) Date of publication and mention of the grant of the patent: **22.04.2020**
(21) Application number: 11728228.5
(22) Date of filing: 17.06.2011
(51) Int. Cl.: H01J 37/34, C23C 14/34, B21K 25/00

(54) **METHOD FOR BONDING COMPONENTS OF A SPUTTERING TARGET.**
VERFAHREN ZUM BONDEN VON ELEMENTEN EINES SPUTTERTARGETS.
PROCÉDÉ DE LIAISON D'ÉLÉMENTS D'UNE CIBLE DE PULVÉRISATION CATHODIQUE.

(30) Priority: 28.06.2010 US 344313 P; 18.06.2010 EP 10006343
(43) Date of publication of application: 24.04.2013
(73) Proprietor: Umicore, 1000 Brussels (BE)
(72) Inventor: LINSBOD, Robert, 4020 Linz (AT)
(74) Representative: Umicore RDI Patent Department
(86) International application number: PCT/EP2011/060173
(87) International publication number: WO 2011/157845

(56) References cited:
- US-A1- 2004 056 070
- US-A1- 2004 113 364
- US-A1- 2005 011 749
- WICKERSHAM C ET AL: "Inertial interlock bonding: A new approach to sputtering target construction", JOURNAL OF VACUUM SCIENCE AND TECHNOLOGY: PART A, AVS /AIP, MELVILLE, NY., US, vol. 25, no. 1, 2 January 2007 (2007-01-02), pages 54-60, XP012102558, ISSN: 0734-2101, DOI: DOI:10.1116/1.2388957 cited in the application

## Description

### FIELD OF THE INVENTION

The present invention generally relates to a method for attaching a sputtering target segment to a backing body in order to produce a sputtering target.

### BACKGROUND OF THE INVENTION

Large sputtering targets generally consist of a backing body, e.g. a backing tube or backing plate, on which one or more target segments are bonded, i.e. they are attached to the backing body. These segments can be a variety of shapes. During sputtering, sputtering targets, mostly of very high purity or very exact composition, are exposed to ion bombardment and by consequence high thermal loads. The backing body is therefore water-cooled.

The function of the backing body is to provide for electrical power transfer, mechanical strength, and heat transfer to the cooling water, and it allows the target to be mounted in the sputtering source.

Traditionally the bonding between the target segments and the backing body is mainly obtained via either diffusion bonding or by means of a solder.

Diffusion bonding is based on interdiffusion of atoms across the interface between two materials, in this case the material of the target segment and the material of the backing body, in which one or both materials partly diffuse into each other, creating a continuous, uninterrupted interface with a more or less smooth concentration gradient of the two materials across it.

This bonding method requires surfaces cleaned of impurities, more in particular thin layers of oxides, which would hinder the diffusion, and can therefore only be carried out under vacuum or in a protective atmosphere. This makes the method expensive and complex.

A protective atmosphere is defined as an atmosphere in which oxide on the surfaces cannot form and/or any oxides that may be present are reduced. In essence this means an atmosphere without any significant amount of oxygen, such as an inert gas blanket or a vacuum.

Furthermore a high temperature is often needed to allow sufficient diffusion to take place, higher than is optimal for the target material, which thereby runs the risk of grain growth or other deterioration, decreasing the target material's usability. Among others this is a consideration for aluminium and aluminium alloys.

Soldering, in other words the introduction of a low melting intermediate substance between the target material and the backing body and binding them, also has its disadvantages.

Low melting point solders are often not suitable because the temperature during use of the sputtering target containing the bonded backing body and target segment can increase above the melting point of the solder, causing debonding, also called delamination, whereas higher temperature solders are often brittle and/or require temperatures that, as in diffusion bonding, may deteriorate the properties of the target material.

A particular problem with soldering is that, locally, problems may easily occur when a certain spot on the surface of the sputtering target has less good thermal connection with the backing body than other areas, because in these spots local overheating and melting of the solder may occur, leading to further decreased heat transfer, progressively leading to delamination.

A disadvantage is also that a costly solder has to be used.

Both bonding methods can be improved by creating matching or approximately matching grooves and ridges in the backing body and the target segments, first increasing the interfacial area and secondly allowing for some degree of mechanical interlocking, while keeping soldering or diffusion bonding as the main bonding mechanisms.

This is described for instance in J. Vac. Sci. Technol. A25(1), Jan/Feb 2007, p. 54-60 for the case of soldering and in US2010/0038241A1 for the case of diffusion bonding.

In both technologies the backing body and the target segment are provided with ridges and corresponding grooves. This has the disadvantages that it requires an additional processing step to create these grooves and ridges, as well as imposes further costs, because target material, which is often very expensive due to its high purity and/or exact composition is mechanically removed and wasted.

A further problem poses itself when disposing of the used targets. With both above mentioned technologies a piece consisting of multiple materials, possibly contaminated with solder, remains after use, making recycling of the used sputtering targets difficult and expensive.

It is therefore an objective of the invention to provide a solution to one or more of the above-mentioned or other disadvantages.

### SUMMARY OF THE INVENTION

To this end the present invention provides a method for bonding a connection surface of a first component of a sputtering target to a connection surface of a second component of a sputtering target, which comprises the following steps: providing a first component and a second component, the harder of which has on its connection surface at least one part which protrudes relative to at least one other part of the same connection surface and which has an undercut; positioning the connection surface of the first component and the connection surface of the second component against each other; pressing the first component and the second component towards each other resulting in a plastic deformation of the material of at least one of the region of the connection surface of the first component and the region of the connection surface of the second component, filling at least partly at least one undercut to such an extent that interlocking of the second component and the first component is thereby obtained, and which has no step creating bonding other than interlocking on a major part of the bonded surface area.

This has the advantage that it provides a simple, cheap, and heat-resistant way to bond two components of a sputtering target, which can additionally be executed without the need for a protective atmosphere or the need for a solder.

In an embodiment of the method according to the invention the first component is a backing body and the second component is a target segment.

This has the advantage that also a sputtering target with a straightforward construction can be cheaply and easily bonded.

In another embodiment the method according to the invention consists of the three mentioned steps.

In a further embodiment, one of the connection surface of the first component and the connection surface of the second component is flat. This has the advantage that more money is saved by not having to provide protrusions or grooves on this connection surface, but only on the other one, which saves on processing costs, as well as on material that would otherwise go to waste.

In yet a further embodiment the interlocking is the only bonding mechanism. This is advantageous since no solder needs to be supplied. Additionally, no cross-contamination of the materials at the interfaces occurs which would happen when using diffusion bonding, making recycling easier.

In a specific embodiment, the major part of the bonded surface area is free from solder, and diffusion bonding does not occur to any practical extent.

In another specific embodiment, the mentioned steps are not executed under a protective atmosphere or under vacuum. An advantage is that this is cheaper and easier since no protective atmosphere or vacuum with an associated closed chamber needs to be provided.

In another aspect of the invention, the pressing step is executed in a mould which has punches that have a curvature so as to impart the same curvature on the bonded second component and first component present in the mould during pressing.

This has the advantage that a desired curvature of the bonded second component and first component can be obtained, for instance a flat surface of one of the components, or a specific curvature that optimizes properties during use of the sputtering target comprising the second component and the first component. In order to do this, the curvature of the punches needs to be adjusted to the desired curvature of the bonded second component and first component, among others by taking into account the thermal expansion coefficients of the materials used.

In specific embodiments, the protruding parts are ridges and the cross-section of the ridges is approximately T-shaped.

This has the advantages that these are relatively easy to produce and allow for a good control and optimization of the behavior of the materials during pressing, the bonding strength and the bonding elasticity, all taking the specific properties of the materials used in a specific case into account.

In another specific embodiment, the processing conditions, such as temperature, time and pressure of the various steps and the presence or absence of pre- or posttreatments, and the geometric features, such as size, shape and spacing, of the at least one protruding part, are chosen so that the bonding is reversible by mechanical means and the first component can be re-used after reversal of the bonding without any operation altering its geometry.

This has the advantages that no new first component needs to be made for a bonding with a new second component, but that the first component can be used several times.

This embodiment can be combined with the previously mentioned embodiment in which the major part of the bonded surface area is free from solder, and diffusion bonding does not occur to any practical extent.

This combination leads advantageously to minimizing the chemical contamination of the remainder of the second component after use, so that it becomes easier and cheaper to recycle this in a purification process.

### BRIEF DESCRIPTION OF THE DRAWINGS

With the intention of better showing the characteristics of the invention, hereafter, as an example without any limitative character, a method of bonding a target segment to a backing plate is described and illustrated by means of the following figures:
Figure 1:shows a schematic view in perspective of the first step of a method according to the invention to bond a ridged backing plate to a target segment;
Figure 2: shows a section through part of a backing plate and target segment in an unbonded position;
Figure 3: shows a section through curved mould parts and the backing plate and target segment of figure 1;
Figure 4: shows a section through part of a backing plate and target segment in a bonded position.

### DETAILED DESCRIPTION

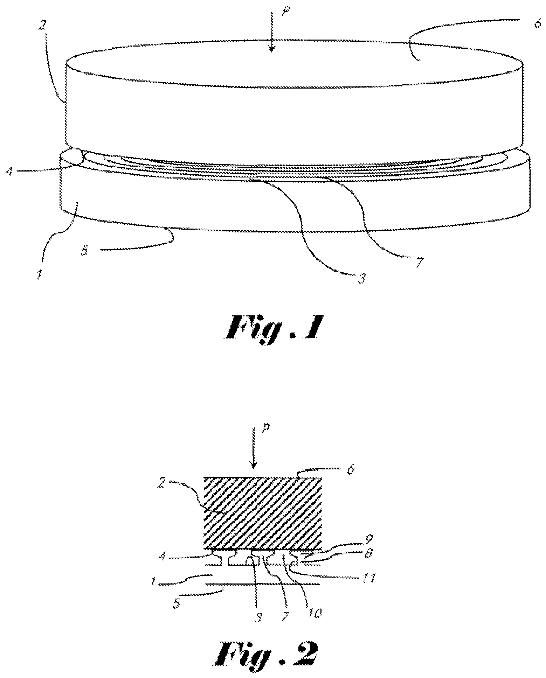

As shown in figure 1, a copper disk with a hardness of 93 HBW is provided as a backing plate 1 and a slightly smaller aluminium disk of 99.9995% purity with a hardness of 14 HBW as a sputtering target segment 2. The backing plate 1 has a first connection surface 3 and the target segment 2 has a second connection surface 4, intended for mutual bonding. The backing plate 1 has a first rear surface 5 and the target segment 2 has a second rear surface 6. The backing plate 1 is provided with a plurality of ridges 7 on the first connection surface 3 which are positioned in a concentric pattern on this surface 3.

As shown in figure 2 the target segment 2 does not have ridges 7 or other protrusions and has a flat connection surface 4.

The ridges 7 are approximately T-shaped and can be considered to consist of a stem 8, one extreme of which is connected to the first connection surface 3 and a crossbar 9 which is slightly narrower at its extremes than in the middle and which is connected at its middle to the other extreme of the stem 8.

The ridges 7 are formed or can be formed by machining away the material from corresponding grooves 10, but may be formed in a different manner as well. The ridges 7 have undercuts 11 which are part of the grooves 10.

The diameter of the target segment 2 is circa 30 cm. The ridges 7 provided are spaced 5.2 mm and extend 2 mm out of the first connection surface 3. The stems 8 are 1 mm long and wide, and the top width of the ridges 7 is 2.4 mm. At both ends the crossbar 9 has a thickness of circa 0.6 mm

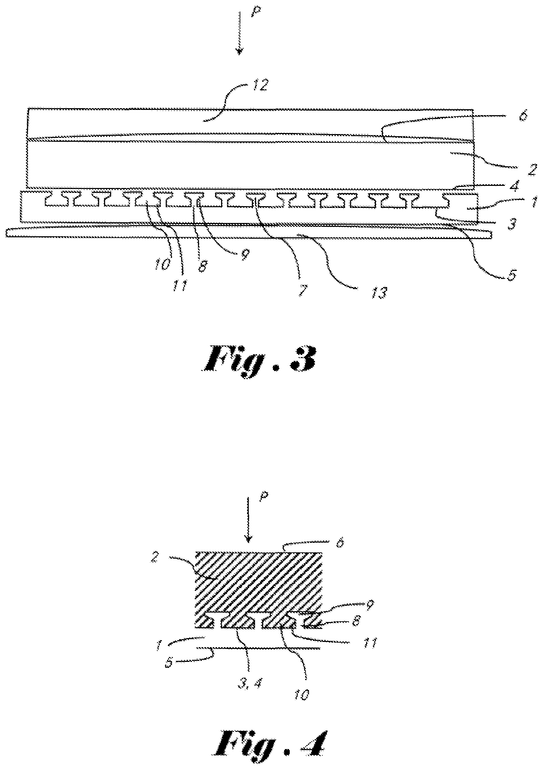

The backing plate 1 and the target segment 2 are placed in the desired position in a mould of which for clarity only the punches 12,13 are illustrated in figure 3. The two punches 12, 13 of the mould, exerting force on the first and second rear surfaces 5,6 during pressing, have a slight curvature, one of which is concave and the other convex, and which preferably match each other.

In this particular case punch 13, which is in contact with the backing plate 1 during pressing, is convex.

The backing plate 1, the target segment 2 and the mould components, among which the punches 12, 13, are heated in a furnace to 250 °C. This can be done before assembling the mould and placing the backing plate 1 and the target segment 2 in it, or after.

A press is prepared. The heated mould with the backing plate 1 and target segment 2 are put in the press, and pressed for 6 minutes with a pressure of approximately 56 MPa measured on the overall contact area between the target segment 2 and the backing plate 1, in the direction indicated by arrow P in the figures.

All operations are performed in ambient atmospheric conditions, so under air, without the need for any protective atmosphere.

During this pressing step the material of the region of the second connection surface 4 is plastically deformed filling the grooves 10, including the undercuts 11, thereby creating interlocking between the backing plate 1 and the target segment 2, as is illustrated in figure 4.

A complete filling of the grooves 10 and the cavities formed by the undercuts 11 occurs in this case but this is not always necessary, nor a condition for the method of the invention. The bonding effect becomes stronger, the thermal connection between the backing plate 1 and the target segment 2 improves and possible problems with air inclusions while using the bonded backing plate 1 and target segment 2 may be lessened if the grooves 10 and undercuts 11 are filled to a higher extent.

In general it is preferred if the undercuts 11 are filled to at least 50%, whereas a better result is obtained if the undercuts 11 are filled to 90% or more.

No solder needs to be provided between the backing plate and the target segment, but some solder may be provided locally without departing from the scope of the invention, for reasons other than bonding.

Also during the pressing step the backing plate 1 and the target segment 2 become slightly curved in a radial direction, due to the curvature of punches 12 and 13. In this particular case the first connection surface 3 becomes slightly convex.

After the pressing step the bonded backing plate 1 and target segment 2 are allowed to cool down, upon which, due to the difference in thermal expansion coefficient of the materials and the curvature imposed upon them during pressing, they become approximately flat.

Obviously the curvature of the punches 12 and 13 can be adapted so that a residual curvature, either concave or convex, remains if desired.

The bonding strength was determined to be around 20 MPa.

The pressing does not necessarily have to be executed at elevated temperature, but can also be done at room temperature, although pressure has to be increased, and a more powerful and more expensive press may therefore become necessary. The usable conditions can be found through routine experimentation.

The assembly of the bonded backing plate 1 and target segment 2 can now be further processed via known operations in the industry to form a sputtering target. No further steps providing bonding between the backing plate 1 and the target segment 2 need to be taken. More in particular no diffusion bonding step is needed, and therefore no high temperature processing step in a protective atmosphere or vacuum is needed. To ensure vacuum tightness, the outer boundary of the bonded surface area can be sealed by known methods in the industry.

In the above example only two components are bonded to form a sputtering target, the target segment 2 and the backing plate 1. However, it is within the scope of the invention that more than two components of a sputtering target may also be bonded analogously.

For instance a target segment 2 and a backing body 1 may be bonded by providing a third component, an intermediate layer of a softer material, between them. Alternatively, a hard third component, a layer with ridges on both sides, may be used to bond a softer target segment 2 to a softer backing body 1.

The bonding by means of one or more intermediate components may be done in one pressing step, in which all of the components are bonded simultaneously, or in several pressing steps, in which components are bonded to each other one by one, possibly with intermediate processing taking place between the separate pressing steps.

Due to the fact that in this case the operations are executed in ambient atmosphere, which produces a thin oxide layer on the surface, and at low temperature, diffusion bonding, which requires metal to metal molecular contact and elevated temperatures is not expected to take place.

After use, the backing plate 1 and the remainder of the target segment 2 can be separated again by applying sufficient force. The remainder of the target segment 2 becomes mechanically damaged in this step but contains no or very little chemical contamination due to the absence of diffusion bonding or soldering, so that it can be recycled easily and cheaply by chemical and/or metallurgical processes. The backing plate 2 remains mechanically substantially undamaged and may be re-used.

The dimensions, spacing and distribution of the ridges 10 can be adapted to the mechanical properties of the materials to be bonded at the desired pressing conditions, ensuring at the same time good plastic deformation of the weaker of the materials due to the stresses applied during pressing, sufficient bonding strength, and relatively easy separation of the bonded backing plate 1 and target segment 2 after use. Basic knowledge of the mechanical properties of the materials, such as for instance hardness, yield stress and rupture stress, will allow the skilled person to determine which geometries are usable in specific situations.

A significant difference in mechanical properties, such as for instance described by the hardness, between the backing body 1 and the target segment 2 is advantageous for an easy application of the method. The extent to which the hardness needs to be different also depends on the geometry of the ridges or other protrusions and on the yield strength of the softer material that is used.

In general, good results are obtained when the hardness difference is at least 20 HBW, better results are obtained when the hardness difference is at least 40 HBW, and even better results are obtained with a hardness difference of 60 HBW or more.

An additional tempering step, to recrystallize the deformed material of the target segment 2 after pressing, may be used if desired. In the pressing conditions described above with the materials described above, recrystallization occurs already during pressing and such a step would therefore be superfluous.

The method described is not limited to the materials mentioned but can also be used with backing bodies 1 and target segments 2 made from other materials which are used in sputtering. These can for instance be one or a combination, mixture or alloy of copper, aluminium, lithium, magnesium, silver, gold, silicon, indium, tin, thallium, lead, bismuth, antimony, cadmium, sodium, potassium, beryllium, calcium, strontium, barium, tellurium or compounds based on these elements.

As in common metallurgical use of the word alloy, an alloy of a certain metal is also understood to comprise those alloys that contain a significant, especially major, portion of this certain metal, and other constituents, whether these other constituents form part of the above mentioned metals or not.

Examples of suitable aluminium alloys are ALSi1, AlSi1Cu0.5 and AlCu0.5, in which the numbers indicate weight percentages of the alloying elements.

A limited range of materials, such as silver, can display diffusion bonding also in conditions such as used in this example. If this is to be avoided, for recycling reasons, a very thin coating can be applied on the backing body and/or target segment to avoid this.

In certain cases, without departing from the scope of the invention, a backing body 1 consisting of more than one layer of different materials, for instance a layer of deformable material to effect good bonding near the first connection surface 3 and a layer of stronger material further away from this surface 3 to provide sufficient rigidity, may be used.

Analogously a target segment 2 consisting of several layers of different materials may be used.

The bonding between these different layers may be done with conventional technologies or according to the present invention.

In the present example a unidirectional press with one moving punch and without heating was used. It will be clear that other presses, including those provided with a system for heating the mould and/or pressed materials, and with multiple moving punches or rolls can be used.

It is in general cheaper to keep the connection surface of the softer of the backing body 1 and the target segment 2 flat, because in that case no processing needs to be done on the second connection surface 4. The method according to the invention may however equally be executed with a non-flat first or second connection surface 3,4 on the softer of the backing body 1 and the target segment 2, or with such first and second connection surfaces 3,4 prepared to contain protrusions partly or completely matching the grooves 10 on the other connection surface 4,3.

The present invention is in no way limited to method variant described here above, however, such an improved method can be realized in various forms without leaving the scope of the invention.

## Claims

1. A method for bonding a connection surface of a first component of a sputtering target to a connection surface of a second component of a sputtering target comprising the following steps:
- providing a first component and a second component, at least the harder of which has on its connection surface at least one part which protrudes relative to at least one other part of the same connection surface and which has an undercut;
- positioning the connection surface of the first component and the connection surface of the second component against each other;
- pressing the first component and the second component towards each other resulting in a plastic deformation of the material of at least one of the region of the connection surface of the first component and the region of the connection surface of the second component filling at least partly at least one undercut to such an extent that interlocking of the second component and the first component is thereby obtained,
and in that there is no step creating bonding other than interlocking on a major part of the bonded surface area.

2. The method according to claim 1, wherein the first component is a backing body and the second component is a target segment.

3. The method according to claim 1, wherein one of the connection surface of the first component and the connection surface of the second component is flat just before pressing.

4. The method according to claim 1, wherein all or approximately all undercuts are completely or approximately completely filled during the pressing step.

5. The method according to claim 1, wherein at least the major part of the bonded surface area is free from solder.

6. The method according to claim 1, wherein it is executed in conditions which do not allow for diffusion bonding to occur to any practical extent.

7. The method according to claim 1, wherein the previously mentioned steps are the only steps creating bonding between the connection surface of the first component and the connection surface of the second component.

8. The method according to claim 1, wherein the interlocking is the only bonding mechanism.

9. The method according to claim 1, wherein the mentioned steps are not executed under a protective atmosphere or under vacuum.

10. The method according to claim 1, wherein the pressure is applied mainly in a direction perpendicular to the connection surface of the first component and the connection surface of the second component.

11. The method according claim 1, wherein the pressing step is executed in a mould which has punches that have a curvature so as to impart during pressing the same curvature on the bonded first component and second component present in the mould.

12. The method according to claim 1, wherein the first component is a backing plate.

13. The method according claim 1, wherein the at least one protruding part is provided in the form of one or several ridges.

14. The method according to claim 13, wherein the ridges are provided as multiple concentric circles.

15. The method according to claim 13, wherein the cross-section of the ridges is approximately T-shaped.

16. The method according to claim 1, wherein protruding parts are provided in a regular pattern.

17. The method according claim 1, wherein the at least one protruding part is provided on the first component.

18. The method according to claim 1, wherein the first component is made of copper or a copper alloy.

19. The method according to claim 1, wherein the second component is made of one or a combination, mixture or alloy of the materials from the group aluminium, lithium, magnesium, silver, gold, indium, tin, thallium, lead, bismuth, antimony, cadmium, sodium, potassium, beryllium, calcium, strontium, barium, tellurium or compounds based on these elements.

20. The method according to claim 19, wherein the second component is made of aluminium or an aluminium alloy.

21. The method according to claim 1, wherein the pressing is executed at a temperature between room temperature and 300 °C

22. The method according to claim 21, wherein the pressing is executed at a temperature between 200 and 300 °C

23. The method according to claim 1, wherein the pressure component applied in the direction perpendicular to the connection surface of the first component and the connection surface of the second component is between 20 and 120 MPa, measured on the overall area of the bonded part of the connection surface of the first component and the connection surface of the second component.

24. The method according to claim 1, wherein the bonding is reversible.

25. The method according to claim 24, wherein the processing conditions and/or the geometric features of the at least one protruding part are chosen so that the bonding is reversible by mechanical separation of the first component and the second component.

## Patentansprüche

1. Verfahren zum Bonden einer Verbindungsfläche einer ersten Komponente eines Sputtertargets mit einer Verbindungsfläche einer zweiten Komponente eines Sputtertargets, umfassend die folgenden Schritte:
- Bereitstellen einer ersten Komponente und einer zweiten Komponente, von denen mindestens die härtere auf ihrer Verbindungsfläche mindestens ein Teil aufweist, das relativ zu mindestens einem anderen Teil derselben Verbindungsfläche vorsteht und das eine Hinterschneidung aufweist;
- Positionieren der Verbindungsfläche der ersten Komponente und der Verbindungsfläche der zweiten Komponente gegeneinander;
- Pressen der ersten Komponente und der zweiten Komponente gegeneinander, was dazu führt, dass eine plastische Verformung des Materials von mindestens einem von dem Bereich der Verbindungsfläche der ersten Komponente und dem Bereich der Verbindungsfläche der zweiten Komponente zumindest teilweise eine Hinterschneidung in einem solchen Ausmaß füllt, dass hierdurch ein Ineinandergreifen der zweiten Komponente und der ersten Komponente erlangt wird,
und dass es keinen Schritt gibt, der ein anderes Bonden als das Ineinandergreifen an einem Hauptteil des gebondeten Oberflächenbereichs schafft.

2. Verfahren nach Anspruch 1, wobei die erste Komponente ein Rückkörper ist und die zweite Komponente ein Targetsegment ist.

3. Verfahren nach Anspruch 1, wobei eine von der Verbindungsfläche der ersten Komponente und der Verbindungsfläche der zweiten Komponente kurz vor dem Pressen eben ist.

4. Verfahren nach Anspruch 1, wobei alle oder annähernd alle Hinterschneidungen während des Pressschritts vollständig oder annähernd vollständig gefüllt werden.

5. Verfahren nach Anspruch 1, wobei mindestens der Hauptteil des gebondeten Oberflächenbereichs frei von Lot ist.

6. Verfahren nach Anspruch 1, wobei es unter Bedingungen ausgeführt wird, die das Auftreten von Diffusionsbonding in irgendeinem geeigneten Ausmaß nicht zulassen.

7. Verfahren nach Anspruch 1, wobei die zuvor genannten Schritte die einzigen Schritte sind, die ein Bonden zwischen der Verbindungsfläche der ersten Komponente und der Verbindungsfläche der zweiten Komponente schaffen.

8. Verfahren nach Anspruch 1, wobei das Ineinandergreifen der einzige Bondingmechanismus ist.

9. Verfahren nach Anspruch 1, wobei die erwähnten Schritte nicht unter einer Schutzatmosphäre oder unter Vakuum ausgeführt werden.

10. Verfahren nach Anspruch 1, wobei der Druck im Wesentlichen in einer Richtung senkrecht zu der Verbindungsfläche der ersten Komponente und der Verbindungsfläche der zweiten Komponente ausgeübt wird.

11. Verfahren nach Anspruch 1, wobei der Pressschritt in einer Form ausgeführt wird, die Stempel mit einer Krümmung aufweist, um die gebondete erste Komponente und zweite Komponente in der Form während des Pressens mit der gleichen Krümmung zu versehen.

12. Verfahren nach Anspruch 1, wobei die erste Komponente eine Rückplatte ist.

13. Verfahren nach Anspruch 1, wobei das mindestens eine vorstehende Teil in der Form von einer oder mehreren Rippen bereitgestellt wird.

14. Verfahren nach Anspruch 13 wobei die Rippen als mehrere konzentrische Kreise bereitgestellt werden.

15. Verfahren nach Anspruch 13, wobei der Querschnitt der Rippen etwa T-förmig ist.

16. Verfahren nach Anspruch 1, wobei vorstehende Teile in einem regelmäßigen Muster bereitgestellt werden.

17. Verfahren nach Anspruch 1, wobei das mindestens eine vorstehende Teil an der ersten Komponente bereitgestellt wird.

18. Verfahren nach Anspruch 1, wobei die erste Komponente aus Kupfer oder einer Kupferlegierung besteht.

19. Verfahren nach Anspruch 1, wobei die zweite Komponente aus einem oder einer Kombination, Mischung oder Legierung der Materialien aus der Gruppe aus Aluminium, Lithium, Magnesium, Silber, Gold, Indium, Zinn, Thallium, Blei, Wismut, Antimon, Kadmium, Natrium, Kalium, Beryllium, Calciums, Strontium, Barium, Tellur oder Verbindungen auf der Basis dieser Elemente besteht.

20. Verfahren nach Anspruch 19, wobei die zweite Komponente aus Aluminium oder einer Aluminiumlegierung besteht.

21. Verfahren nach Anspruch 1, wobei das Pressen bei einer Temperatur zwischen Raumtemperatur und 300 °C durchgeführt wird.

22. Verfahren nach Anspruch 21, wobei das Pressen bei einer Temperatur zwischen 200 und 300 °C durchgeführt wird.

23. Verfahren nach Anspruch 1, wobei die Druckkomponente, die in der Richtung senkrecht zu der Verbindungsfläche der ersten Komponente und der Verbindungsfläche der zweiten Komponente ausgeübt wird, zwischen 20 und 120 MPa liegt, gemessen auf der Gesamtfläche des gebondeten Teils der Verbindungsfläche der ersten Komponente und der Verbindungsfläche der zweiten Komponente.

24. Verfahren nach Anspruch 1, wobei das Bonden reversibel ist.

25. Verfahren nach Anspruch 24, wobei die Verarbeitungsbedingungen und/oder die geometrischen Merkmale des mindestens einen vorstehenden Teils derartig gewählt werden, dass das Bonden durch mechanische Trennung der ersten Komponente und der zweiten Komponente reversibel ist.

## Revendications

1. Procédé de liaison d'une surface de raccordement d'un premier composant d'une cible de pulvérisation à une surface de raccordement d'un deuxième composant d'une cible de pulvérisation comprenant les étapes suivantes :
- fourniture d'un premier composant et d'un deuxième composant, dont au moins le plus dur a sur sa surface de raccordement au moins une partie qui fait saillie par rapport à au moins une autre partie de la même surface de raccordement et qui a une contre-dépouille ;
- positionnement de la surface de raccordement du premier composant et de la surface de raccordement du deuxième composant l'une contre l'autre ;
- pressage du premier composant et du deuxième composant l'un vers l'autre entraînant une déformation permanente du matériau d'au moins l'une parmi la région de la surface de raccordement du premier composant et la région de la surface de raccordement du deuxième composant remplissant au moins partiellement au moins une contre-dépouille dans une mesure telle qu'un entrelacement du deuxième composant et du premier composant est ainsi obtenu,
et en ce qu'il n'y a aucune étape créant de liaison autre qu'un entrelacement sur une partie principale de la superficie liée.

2. Procédé selon la revendication 1, dans lequel le premier composant est un corps de support et le deuxième composant est un segment de cible.

3. Procédé selon la revendication 1, dans lequel l'une parmi la surface de raccordement du premier composant et la surface de raccordement du deuxième composant est plate juste avant pressage.

4. Procédé selon la revendication 1, dans lequel toutes ou à peu près toutes les contre-dépouilles sont complètement ou à peu près complètement remplies pendant l'étape de pressage.

5. Procédé selon la revendication 1, dans lequel au moins la majeure partie de la superficie liée est exempte de soudure.

6. Procédé selon la revendication 1, dans lequel il est exécuté dans des conditions qui ne permettent pas qu'une liaison par diffusion se produise dans n'importe quelle mesure possible.

7. Procédé selon la revendication 1, dans lequel les étapes mentionnées précédemment sont les seules étapes créant une liaison entre la surface de raccordement du premier composant et la surface de raccordement du deuxième composant.

8. Procédé selon la revendication 1, dans lequel l'entrelacement est le seul mécanisme de liaison.

9. Procédé selon la revendication 1, dans lequel les étapes mentionnées ne sont pas exécutées sous une atmosphère protectrice ou sous vide.

10. Procédé selon la revendication 1, dans lequel la pression est appliquée principalement dans une direction perpendiculaire à la surface de raccordement du premier composant et à la surface de raccordement du deuxième composant.

11. Procédé selon la revendication 1, dans lequel l'étape de pressage est exécutée dans un moule qui a des poinçons qui ont une courbure de façon à conférer pendant le pressage la même courbure sur le premier composant et le deuxième composant liés présents dans le moule.

12. Procédé selon la revendication 1, dans lequel le premier composant est une plaque de support.

13. Procédé selon la revendication 1, dans lequel l'au moins une partie saillante se présente sous la forme d'une ou plusieurs crêtes.

14. Procédé selon la revendication 13, dans lequel les crêtes sont fournies en tant que multiples cercles concentriques.

15. Procédé selon la revendication 13, dans lequel la coupe transversale des crêtes est à peu près en forme de T.

16. Procédé selon la revendication 1, dans lequel les parties saillantes sont fournies dans un motif régulier.

17. Procédé selon la revendication 1, dans lequel l'au moins une partie saillante est fournie sur le premier composant.

18. Procédé selon la revendication 1, dans lequel le premier composant est constitué de cuivre ou d'un alliage de cuivre.

19. Procédé selon la revendication 1, dans lequel le deuxième composant est constitué d'un ou d'une combinaison, d'un mélange ou d'un alliage des matériaux provenant du groupe aluminium, lithium, magnésium, argent, or, indium, étain, thallium, plomb, bismuth, antimoine, cadmium, sodium, potassium, béryllium, calcium, strontium, baryum, tellure ou de composés à base de ces éléments.

20. Procédé selon la revendication 19, dans lequel le deuxième composant est constitué d'aluminium ou d'un alliage d'aluminium.

21. Procédé selon la revendication 1, dans lequel le pressage est exécuté à une température comprise entre la température ambiante et 300 °C

22. Procédé selon la revendication 21, dans lequel le pressage est exécuté à une température comprise entre 200 et 300 °C

23. Procédé selon la revendication 1, dans lequel la composante de pression appliquée dans la direction perpendiculaire à la surface de raccordement du premier composant et à la surface de raccordement du deuxième composant est comprise entre 20 et 120 MPa, mesurée sur l'aire globale de la partie liée de la surface de raccordement du premier composant et de la surface de raccordement du deuxième composant.

24. Procédé selon la revendication 1, dans lequel la liaison est réversible.

25. Procédé selon la revendication 24, dans lequel les conditions de traitement et/ou les caractéristiques géométriques de l'au moins une partie saillante sont choisies de sorte que la liaison est réversible par séparation mécanique du premier composant et du deuxième composant.
